(19) Europäisches Patentamt
European Patent Office
Office européen des brevets

(11) EP 1 095 998 B1

(12) **EUROPÄISCHE PATENTSCHRIFT**

(45) Veröffentlichungstag und Bekanntmachung des Hinweises auf die Patenterteilung:
**10.03.2004 Patentblatt 2004/11**

(51) Int Cl.$^7$: **C09K 11/80**, C09K 11/78, H01L 33/00, H05B 33/14

(21) Anmeldenummer: **00122549.9**

(22) Anmeldetag: **16.10.2000**

(54) **Leuchtstoff für Lichtquellen und zugehörige Lichtquelle**

Luminescent substance for light sources and corresponding light sources

Substance luminescente pour sources lumineuses et sources lumineuses correspondantes

(84) Benannte Vertragsstaaten:
**AT BE CH CY DE DK ES FI FR GB GR IE IT LI LU MC NL PT SE**

(30) Priorität: **27.10.1999 DE 19951790**

(43) Veröffentlichungstag der Anmeldung:
**02.05.2001 Patentblatt 2001/18**

(73) Patentinhaber: **Patent-Treuhand-Gesellschaft für elektrische Glühlampen mbH**
**81543 München (DE)**

(72) Erfinder:
- **Ellens, Andries, Dr.**
**81735 München (DE)**
- **Zwaschka, Franz, Dr.**
**85737 Ismaning (DE)**

(56) Entgegenhaltungen:
**WO-A-00/36051**
**GB-A- 2 000 173**
**US-A- 4 550 256**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

### Technisches Gebiet

Die Erfindung geht aus von einem Leuchtstoff für Lichtquellen und zugehörige Lichtquelle gemäß dem Oberbegriff des Anspruchs 1. Es handelt sich dabei insbesondere um einen im langwelligen Bereich des Sichtbaren Spektralbereichs emittierenden Granat-Leuchtstoff für die Anregung durch kurze Wellenlängen im sichtbaren Spektralbereich. Als Lichtquelle eignet sich insbesondere eine Lampe (vor allem Leuchtstofflampe) oder eine LED (light emitting diode), die insgesamt beispielsweise weißes Licht erzeugt.

### Stand der Technik

Aus der WO 98/05078 ist bereits ein Leuchtstoff für Lichtquellen und zugehörige Lichtquelle bekannt. Als Leuchtstoff wird dort ein Granat der Struktur $A_3B_5O_{12}$ eingesetzt, dessen Wirtsgitter als erste Komponente A aus mindestens einer der Seltenen Erdmetalle Y, Lu, Sc, La, Gd oder Sm besteht. Weiter wird für die zweite Komponente B eines der Elemente Al, Ga oder In verwendet. Als Aktivator wird ausschließlich Ce eingesetzt.

Aus der WO 97/50132 ist ein sehr ähnlicher Leuchtstoff bekannt. Als Aktivator wird dort entweder Ce oder Tb eingesetzt. Während Ce im gelben Spektralbereich emittiert, liegt die Emission des Tb im grünen Spektralbereich. In beiden Fällen wird das Prinzip der Komplementärfarbe (blau emittierende Lichtquelle und gelb emittierender Leuchtstoff) zur Erzielung einer weißen Lichtfarbe mit einem Halbleiterbauelement verwendet.

Schließlich ist in EP-A 124 175 eine Leuchtstofflampe beschrieben, die neben einer Quecksilberfüllung mehrere Leuchtstoffe enthält. Diese werden durch die UV-Strahlung (254 nm) oder auch durch die kurzwellige Strahlung bei 460 nm angeregt. Drei Leuchtstoffe sind so gewählt, daß sie sich zu weiß addieren (Farbmischung).

### Darstellung der Erfindung

Es ist Aufgabe der vorliegenden Erfindung, einen Leuchtstoff gemäß dem Oberbegriff des Anspruchs 1 bereitzustellen, der beständig gegen hohe thermische Belastung ist und sich gut für die Anregung im kurzwelligen sichtbaren Spektralbereich eignet.

Diese Aufgabe wird durch die kennzeichnenden Merkmale des Anspruchs 1 gelöst. Besonders vorteilhafte Ausgestaltungen finden sich in den abhängigen Ansprüchen.

Im einzelnen wird erfindungsgemäß ein Leuchtstoff für die Anregung durch eine Strahlungsquelle vorgestellt, deren Emission im kurzwelligen optischen Spektralbereich liegt. Der Leuchtstoff hat eine Granatstruktur $A_3B_5O_{12}$, und er ist mit Ce dotiert und aktiviert, wobei die zweite Komponente B mindestens eines der Elemente Al und Ga repräsentiert. Die erste Komponente A enthält ein Seltenerdmetall SE aus der Gruppe Y, Sc, Gd, Tb, La und/oder Lu, wobei ein Anteil von maximal 5 Mol.-% von A durch Praseodym (Pr) ersetzt ist. Wegen der bei Pr zu beobachtenden Konzentrationslöschung ist vor allem ein Anteil von höchstens 5 Mol-% zu empfehlen. Besonders günstig ist ein Anteil von höchstens 1 Mol.-%. Hierbei wirkt Praseodym als zweiter Aktivator neben Ce entsprechend der Formel $A_3B_5O_{12}$:(Ce,Pr).

Vorteilhaft wird die erste Komponente A überwiegend (mehr als 75% Mol.-%) durch Yttrium u/o Lutetium gebildet um eine hohe Ausbeute zu erzielen. Daneben können Anteile von Tb, Sc, Gd u/o La zur Feinabstimmung verwendet werden. Besonders vorteilhaft ist die Zugabe von Tb zur Komponente A in geringen Mengen (0,1 bis 20 Mol.-%), da Tb die Temperatur-Löschung verbessert. Gute Ergebnisse liefert insbesondere ein Granat $(Y,Tb)_3Al_5O_{12}$:(Ce,Pr).

Der erfindungsgemäße Leuchtstoff ist in einem weiten Bereich des blauen Spektralbereichs durch eine Strahlung im Bereich 420 bis 490 nm, insbesondere 430 bis 470 nm, anregbar. Eine besonders gute Anpassung lässt sich an eine Lichtquelle erzielen, deren Peakwellenlänge im Bereich 440 bis 465 nm liegt.

Der Leuchtstoff hat insbesondere eine Granatstruktur $(SE_{1-x-y}Pr_xCe_y)_3(Al,Ga)_5O_{12}$, wobei SE = Y, Sc, Tb, Gd, La und/oder Lu. Die Konzentration der beiden Aktivatoren sollte in folgenden Bereichen gewählt werden:

$$0{,}00005 \le x \le 0{,}05;$$

$$0{,}01 \le y \le 0{,}2.$$

Die zweite Komponente B enthält vorteilhaft sowohl Ga als auch Al und kann zusätzlich In enthalten.

Es hat sich gezeigt, dass die Zugabe von Pr zum YAG:Ce Wirtskristall genau bemessen werden muss, da bei zu hoher Konzentration sich die Lichtausbeute erheblich verschlechtert, während bei zu geringer Konzentration kein merklicher Effekt der Rotverbesserung mehr auftritt. Einen guten Anhaltspunkt für die Bemessung des Pr bieten seine im Emissionsspektrum auftretenden Linien. Insbesondere sollte der Anteil des Praseodym und die Beschaffenheit des Wirtsgitters (Auswahl der A und B Komponente so gewählt sein, dass im wesentlichen Linien des Pr unterhalb 650 nm im Emissionsspektrum erscheinen, insbesondere die beiden Linien des Pr bei 609 und 611 nm. Je kurzwelliger der Rotanteil gewählt werden kann, desto höher ist der visuelle Nutzeffekt, da die Augenempfindlichkeit zu langen Wellenlängen hin sehr stark abnimmt. Daher ist ein Rotanteil, der durch eine Emission bei einer Wellenlänge oberhalb 650 nm erzielt wird, also im Bereich 650 bis 700 nm, wesentlich ungünstiger.

Insbesondere sollte der Anteil des Praseodym unter 0,3 Mol.-% liegen und insbesondere so gering gewählt sein, dass die beiden Linien des Pr bei 609 und 611 nm getrennt aufgelöst im Emissionsspektrum erscheinen. Zusätzlich kann auch bei geeigneter Dimensionierung des Pr-Anteils die Pr-Linie bei 637 nm im Emissionsspektrum erscheinen. Vorteilhaft sollte der Anteil des Praseodym über 0,02 Mol.-% liegen und so hoch gewählt sein, dass die Pr-Linie bei 637 nm deutlich im Emissionsspektrum erscheint. Denn dadurch wird ein zusätzlicher Beitrag im roten Spektralbereich erzielt neben den beiden anderen Hauptlinien des Pr bei 609 und 611 nm. Er sollte insbesondere mindestens 10 % des Beitrags der anderen beiden Linien betragen.

Die vorliegende Erfindung umfaßt auch eine Lichtquelle, die primär Strahlung im kurzwelligen blauen Bereich des optischen Spektralbereichs emittiert, wobei diese Strahlung teilweise oder vollständig mittels eines oben spezifizierten Leuchtstoffs in längerwellige Strahlung konvertiert wird. Insbesondere liegt die primär emittierte Strahlung im Wellenlängenbereich 420 bis 490 nm, insbesondere 430 bis 470 nm. Vorteilhaft wird als primäre Strahlungsquelle eine blau emittierende Leuchtdiode verwendet, insbesondere eine LED auf Basis von InGaN, um eine weiße LED zu realisieren. Eine besonders gute Anpassung von Leuchtstoff und primärer Lichtquelle wird im Bereich einer Peakemission der LED im Bereich 440 bis 465 nm erzielt. Dies geschieht durch Kombination einer blauen LED (primäre Strahlungsquelle) mit einem oben spezifizierten Leuchtstoff, der durch die Strahlung der LED angeregt wird und dessen Emission (sekundäre Strahlungsquelle) die übrig bleibende blaue primäre LED-Strahlung zu weißem Licht ergänzt. Im Falle der Verwendung eines einzigen Pr-haltigen Leuchtstoffs sollte dieser hauptsächlich im Gelben breitbandig und im Roten zusätzlich schmalbandig emittieren. Im Falle der Verwendung zweier Pr-haltigen Leuchtstoffe sollte der eine hauptsächlich im Gelben breitbandig und im Roten zusätzlich schmalbandig emittieren (relativ geringer Pr-Gehalt) während der zweite Leuchtstoff eine Emissionskurve besitzt, die relativ dazu zu längerer Wellenlänge verschoben ist und einen relativ hohen Pr-Gehalt (mehr als 50 % mehr als der erste Leuchtstoff) besitzt. Insbesondere sollte die Konzentration des Pr im ersten Leuchtstoff so gewählt sein, dass nur die beiden Pr-Linien bei 609 und 611 nm in Erscheinung treten, während die Konzentration des zweiten Leuchtstoffs so gewählt werden kann, dass auch die zusätzliche Linie bei 637 nm erscheint und einen Beitrag liefert.

Ein Verfahren zur Herstellung des Leuchtstoffs umfaßt folgende Verfahrensschritte:

Vermahlen der Oxide und Zugabe eines Flußmittels;

Erstes Glühen in Formiergas (Mischung aus $H_2$ und $N_2$);

Mahlen und Sieben;

Zweites Glühen.

Erfindungsgemäß wird ein Leuchtstoff für Lichtquellen, deren Emission im kurzwelligen blauen Spektralbereich liegt, verwendet, der eine Granatstruktur $A_3B_5O_{12}$ besitzt und der mit Ce dotiert ist, wobei die zweite Komponente B mindestens eines der Elemente Al und Ga repräsentiert, wobei die erste Komponente A Praseodym enthält. Überraschenderweise hat sich herausgestellt, daß sich Praseodym (Pr) gut als zusätzlicher Aktivator im Wirtsgitter (erste Komponente A des Granats) eignet, beispielsweise bei blauer Anregung im Bereich 420 bis 490 nm. Der übliche Emissionsbereich des Basis-Leuchtstoffs vom Typ YAG:Ce-Material, dessen Dotierstoff Cer ist, ist breitbandig im Gelben. Durch die Anwesenheit des $Pr^{3+}$ in Material vom Typ YAG:$Ce^{3+}$ wird zusätzliches rotes Licht emittiert, wodurch der Farbort in einem größeren Bereich gesteuert werden kann und die Farbwiedergabe verbessert wird im Vergleich zu üblichen YAG:Ce-Materialien. Die rote Emission von $Pr^{3+}$ ist möglich, weil das Pr-Ion Licht absorbiert, das vom ersten Aktivator, dem Ce-Ion, emittiert wird (vor allem bei den Wellenlängen 480 bis 500 nm), und wieder emittiert. Ein zweiter überraschenderweise vorhandener Transfermechanismus ist die direkte Energieübertragung vom Ce-Ion zum Pr-Ion. Hier wirkt das Ce-Ion als Sensibilisator für den zweiten Aktivator Pr.

Das weiße Licht wird beispielsweise durch Kombination einer Ga(In)N-LED mit dem Leuchtstoff YAG:Ce erzeugt. Dabei kann, abgesehen vom Pr, insbesondere Yttrium als Hauptbestandteil der ersten Komponente A des Granats in Alleinstellung oder zusammen mit mindestens einem der Seltenerdmetalle Tb, Gd, Sc, La u/o Lu verwendet werden.

Als zweite Komponente wird mindestens eines der Elemente Al oder Ga verwendet. Die zweite Komponente B kann zusätzlich In enthalten.

In einer besonders bevorzugten Ausführungsform wird ein Granat $A_3B_5O_{12}$:(Ce,Pr) mit der stöchiometrischen Struktur
$(SE_{1-x-y}Pr_xCe_y)_3(Al,Ga)_5O_{12}$ verwendet, wobei
SE = Y, Gd, Sc, Tb, La und/oder Lu;

$$0{,}00005 \le x \le 0{,}05;$$

$$0{,}01 \le y \le 0{,}2 \text{ gilt.}$$

Der Leuchtstoff absorbiert im Bereich 400 bis 500 nm, bevorzugt zwischen 430 und 470 nm, und kann so durch die Strahlung einer blauen Lichtquelle, die insbesondere die Strahlungsquelle für eine Lampe oder LED ist, angeregt werden. Gute Ergebnisse wurden mit einer blauen LED erzielt, deren Emissionsmaximum bei 420 bis 465 nm lag. Bei Verwendung von reinem YAG: Ce als Basis hat sich insbesondere ein Bereich von 440 bis 465 nm bewährt, bei Verwendung von Anteilen an Lu und Ga wird eine Peakwellenlänge zwischen 420 und 450 nm empfohlen.

Dieser Leuchtstoff eignet sich besonders für die Verwendung in einer weißen LED, beruhend auf der Kombination einer blauen LED mit dem Granat-Leuchtstoff, der durch Absorption eines Teils der Emission der blauen LED angeregt wird und dessen Emission die übrig bleibende Strahlung der LED zu weißem Licht ergänzt.

Als blaue LED eignet sich insbesondere eine Ga(In)N-LED, aber auch jeder andere Weg zur Erzeugung einer blauen LED mit einer Emission im Bereich 420 bis 490 nm. Insbesondere wird als hauptsächlicher Emissionsbereich 430 bis 470 nm empfohlen, da dann die Effizienz am höchsten ist.

Durch die Wahl von Art und Menge an Seltenerdmetallen SE ist eine Feineinstellung der Lage der Absorptions- und der Emissionsbande möglich.

In Verbindung mit Leuchtdioden eignet sich vor allem ein Bereich für x, der zwischen 0,0005 und 0,01 liegt. Der bevorzugte Bereich von y liegt bei 0,03 bis 0,1.

Der erfindungsgemäße Leuchtstoff eignet sich auch zur Kombination mit anderen Leuchtstoffen, vor allem Grün emittierenden Leuchtstoffen, beispielsweise mit einem Grünleuchtstoff wie Thiometallate, wobei vor allem Gallium als ein Bestandteil des Metallats in Frage kommt, sowie insbesondere auch mit anderen YAG:Ce-Leuchtstoffen, insbesondere eine Varietät, die im langwelligen Bereich (rot) mehr emittiert. Es ist jedoch ein besonderer Vorteil, daß die Pr-Zugabe häufig die Verwendung eines weiteren Leuchtstoffs, der schwerpunktmäßig mehr im roten Spektralbereich emittiert, überflüssig macht.

## Figuren

Im folgenden soll die Erfindung anhand mehrerer Ausführungsbeispiele näher erläutert werden. Es zeigen:

- Figur 1 ein Emissionsspektrum eines Pr-haltigen Granat-Leuchtstoffs;
- Figur 2 ein Remissionsspektrum eines Pr-haltigen Granat-Leuchtstoffs;
- Figur 3 Emissionsspektren von Ce-aktivierten Granat-Leuchtstoffen mit unterschiedlichem Pr-Gehalt;
- Figur 4 ein Halbleiterbauelement, das als Lichtquelle für weißes Licht dient;
- Figur 5 ein Emissionsspektrum einer weißen LED, die den Leuchtstoff von Figur 1 enthält.

## Beschreibung der Zeichnungen

Ein Ausführungsbeispiel eines erfindungsgemäßen Leuchtstoffs hat die Zusammensetzung $(SE_{1-x-y}Pr_xCe_y)_3(Al,Ga)_5O_{12}$, wobei SE = Y, Gd, Tb, Sc, La und/oder Lu;

$$0{,}00005 \leq x \leq 0{,}05;$$

$$0{,}01 \leq y \leq 0{,}2 \text{ gilt.}$$

Der Leuchtstoff absorbiert im Bereich 400-500 nm und kann durch die Strahlung einer blauen LED (Emissionsmaximum zwischen 430-470 nm) effizient angeregt werden. Seine Emission besteht aus einer breiten Bande im Gelben mit einem Maximum bei etwa 550-570 nm und zusätzlichen scharfen Linien bei 609 und 611 nm, die dem Praseodym zuzuordnen sind. Eine weitere schwächere Linie des Pr findet sich im längerwelligen Rot bei 637 nm.

Figur 3 zeigt den Vergleich zwischen einem reinen YAG:Ce Leuchtstoff (1) und zwei Pr-haltigen Leuchtstoffen (2,3). Der erste mit Nummer (2) enthält 0,1 Mol.-% Pr, der zweite mit Nummer (3) 1 Mol.-% Pr, wobei der Anteil des Ce jeweils 4 Mol.-% beträgt. Deutlich macht sich bei hohem Pr-Anteil (Nummer (3)) die Konzentrationslöschung bemerkbar durch geringere Effizienz. Andererseits ist der unterschiedliche Anteil der Pr-Linien am Gesamtspektrum deutlich erkennbar. Bei etwa 0,5 Mol.-% Pr ist die Linie bei 637 nm nur noch schwach erkennbar. Im Vergleich zum reinen YAG:Ce Leuchtstoff wird ein Teil der emittierten Strahlung in die roten Linien des Pr gesteckt.

Der Aufbau einer Lichtquelle für weißes Licht ist in Figur 4 explizit gezeigt. Die Lichtquelle ist ein Halbleiterbauelement (Chip 1) des Typs InGaN mit einer Peakemissionswellenlänge von 465 nm mit einem ersten und zweiten elektrischen Anschluss 2,3, das in ein lichtundurchlässiges Grundgehäuse 8 im Bereich einer Ausnehmung 9 eingebettet ist. Die Ausnehmung hat eine Wand 17, die als Reflektor für die blaue Primärstrahlung vom Chip 1 dient. Die Ausnehmung 9 ist mit einer Vergussmasse 5 gefüllt, die als Hauptbestandteile ein Epoxidgießharz (80 bis 90 Gew.-%) und Leuchtstoffpigmente (weniger als 15 Gew.-%) des Typs (3) enthält. Weitere geringe Anteile entfallen u.a. auf Methylether und Aerosil. Das Spektrum dieser weißen LED ist in Figur 5 gezeigt.

Während die InGaN-LED (Peakemission bei 465 nm) mit einer Farbtemperatur von etwa 5500 K mit dem reinen Vergleichsleuchtstoff (1) eine Farbwiedergabe Ra =75 und R9 = -15 erzielt, erreicht die LED mit dem Leuchtstoff (2) eine Farbwiedergabe von 80 und einen R9 von +3. obwohl der Leuchtstoff (3) noch bessere Werte für Ra und R9 erzielt, ist er aufgrund seiner erheblich geringeren Effizienz weniger gut geeignet.

Durch Variation des Anteils an $Pr^{3+}$ (Anteil x) kann das Intensitätsverhältnis zwischen der gelben Bande und den roten Linien, und damit der Farbort, variiert werden.

Eine verbesserte Farbwiedergabe (im Vergleich zu einem gleichen Basis-Leuchtstoff ohne Pr) wird bereits erzielt, wenn x relativ klein gewählt wird, insbesondere x < 0,005. Gute Ergebnisse hinsichtlich Effizienz liefert die Wahl von x bis maximal 0,01, insbesondere im Bereich 0,0005 < x < 0,005.

Ein Ausführungsbeispiel für die Herstellung ist folgender Weg: Die Komponenten

| | |
|---|---|
| 32.48 g | $Y_2O_3$ |
| 2.07 g | $CeO_2$ |
| 0.051 g | $Pr_6O_{11}$ |
| 26.41 g | $Al_2O_3$ |
| 0.149 g | $BaF_2$ |
| 0.077 g | $H_3BO_3$ |

werden vermischt und in einer 250-ml-PE-Weithalsflasche mit 150 g Aluminiumoxidkugeln von 10 mm Durchmesser 2 h zusammen vermahlen. Die Mischung wird in einem bedeckten Korundtiegel 3 h bei 1550°C in Formiergas (Stickstoff mit 2.3 vol-% Wasserstoff) geglüht. Das Glühgut wird in einer automatischen Mörsermühle gemahlen und durch ein Sieb von 53µm Maschenweite gesiebt. Anschließend erfolgt eine zweite Glühung für 3 h bei 1500°C in Formiergas (Stickstoff mit 0.5 vol% Wasserstoff). Danach wird wie nach der ersten Glühung gemahlen und gesiebt.

Der erhaltene Leuchtstoff entspricht der Zusammensetzung $(Y_{0.959}Ce_{0.04}Pr_{0.001})_3Al_5O_{12}$. Er weist eine kräftig gelbe Körperfarbe auf. Ein Reflexions- und Emissionsspektrum sind als Figur 1 und 2 wiedergegeben.

**Patentansprüche**

1. Leuchtstoff für die Anregung durch eine lichtemittierende Strahlungsquelle, deren Emission im kurzwelligen optischen Spektralbereich zwischen 420 und 490 nm liegt, mit einer Granatstruktur $A_3B_5O_{12}$, der mit Ce aktiviert ist, wobei die zweite Komponente B mindestens eines der Elemente Al und Ga repräsentiert, **dadurch gekennzeichnet, daß** die erste Komponente A ein Seltenerdmetall SE aus der Gruppe Y, Tb, La und/oder Lu enthält, wobei ein Anteil von maximal 5 Mol.-%, insbesondere höchstens 1, Mol.-% von A durch Praseodym ersetzt ist und wobei Praseodym als zweiter Aktivator neben Ce wirkt entsprechend der Formel $A_3B_5O_{12}$:(Ce,Pr).

2. Leuchtstoff nach Anspruch 1, **dadurch gekennzeichnet, dass** die erste Komponente A zusätzlich Gd u/o Sc als nichtleuchtenden Bestandteil des Wirtsgitters enthält.

3. Leuchtstoff nach Anspruch 1, **dadurch gekennzeichnet, daß** die erste Komponente A überwiegend, insbesondere zu mehr als 75 Mol.-%, durch Yttrium gebildet ist.

4. Leuchtstoff nach Anspruch 1, **dadurch gekennzeichnet, daß** der Leuchtstoff durch eine Strahlung im Bereich 430 bis 470 nm, insbesondere mit einer Peakwellenlänge im Bereich 440 bis 465 nm, anregbar ist.

5. Leuchtstoff nach Anspruch 3, **dadurch gekennzeichnet, daß** die erste Komponente neben Y u/o Lu Anteile von Tb, Sc, Gd, u/o La verwendet, insbesondere einen Anteil 0,1 bis 20 Mol.-% Tb.

6. Leuchtstoff nach Anspruch 1, **dadurch gekennzeichnet, daß** ein Granat der gesamten Struktur $(SE_{1-x-y}Pr_xCe_y)_3(Al,Ga)_5O_{12}$ verwendet wird, wobei
SE = Y, Sc, Tb, Gd, La und/oder Lu;
mit einer Konzentration der beiden Aktivatoren Pr und Ce im Bereich:

$$0{,}00005 \leq x \leq 0{,}05;$$

$$0{,}01 \leq y \leq 0{,}2 \text{ gilt.}$$

7. Leuchtstoff nach Anspruch 1, **dadurch gekennzeichnet, daß** die zweite Komponente B sowohl Al als auch Ga enthält, und insbesondere zusätzlich In enthält.

8. Leuchtstoff nach Anspruch 1, **dadurch gekennzeichnet, dass** der Anteil des Praseodym und die Beschaffenheit des Wirtsgitters so gewählt ist, dass im wesentlichen Linien des Pr unterhalb 650 nm im Emissionsspektrum erscheinen, insbesondere die beiden Linien des Pr bei 609 und 611 nm.

9. Leuchtstoff nach Anspruch 8, **dadurch gekennzeichnet, dass** der Anteil des Praseodym unter 0,3 Mol.-% liegt und insbesondere so gering gewählt ist, dass die beiden Linien des Pr bei 609 und 611 nm getrennt aufgelöst im Emissionsspektrum erscheinen.

10. Leuchtstoff nach Anspruch 8, **dadurch gekennzeichnet, dass** der Anteil des Praseodym über 0, 02 Mol.-% liegt und so hoch gewählt ist, dass die Pr-Linie bei 637 nm im Emissionsspektrum erscheint.

11. Lichtquelle, die primär Strahlung im kurzwelligen Bereich des optischen Spektralbereichs im Wellenlängenbereich 420 bis 490 nm emittiert, wobei diese Strahlung teilweise oder vollständig mittels eines, insbesondere eines einzigen, Leuchtstoffs nach einem der vorhergehenden Ansprüche in sekundäre längerwellige Strahlung konvertiert wird.

**12.** Lichtquelle nach Anspruch 9, **dadurch gekennzeichnet, dass** die Strahlung mittels zweier Leuchtstoffe nach einem der Ansprüche 1 bis 8 in längerwellige Strahlung konvertiert wird.

**13.** Lichtquelle nach Anspruch 9, **dadurch gekennzeichnet, dass** sie folgende Merkmale besitzt, um eine weiß emittierende LED zu realisieren:

eine Lichterzeugungseinrichtung, insbesondere eine blau emittierende Leuchtdiode, die die primäre Strahlung emittiert;
eine Wellenlängenumwandlungseinrichtung, die an die Lichterzeugungseinrichtung angeschlossen ist, wobei die primäre Strahlung in die Wellenlängenumwandlungseinrichtung eindringt und dort teilweise in die sekundäre längerwellige Strahlung umgewandelt wird, wobei die Wellenlängenumwandlungseinrichtung mindestens einen, insbesondere einen einzigen, der Leuchtstoffe nach Anspruch 1 bis 8 umfasst,

wobei die Wellenlängenumwandlungseinrichtung ferner eine Vergussmasse umfasst, in dem der oder die Leuchtstoffe dispergiert sind.

**14.** Lichtquelle nach Anspruch 9, **dadurch gekennzeichnet, daß** die primär emittierte Strahlung im Wellenlängenbereich 430 bis 470 nm liegt.

**15.** Lichtquelle nach Anspruch 9, **dadurch gekennzeichnet, daß** als primäre Strahlungsquelle eine blau emittierende Leuchtdiode auf Basis von InGaN verwendet wird, deren Peakemissionswellenlänge im Bereich 440 bis 465 nm liegt.

**16.** Verfahren zur Herstellung eines Leuchtstoffs gemäß einem der Ansprüche 1 bis 6, **gekennzeichnet durch** folgende Verfahrensschritte:

a. Vermahlen der Oxide und Zugabe eines Flußmittels;

b. Erstes Glühen in Formiergas;

c. Mahlen und Sieben;

d. Zweites Glühen.

**Claims**

**1.** Phosphor for excitation by a light-emitting radiation source, the emission from which lies in the shortwave optical spectral region between 420 and 490 nm, having a garnet structure $A_3B_5O_{12}$, which is activated with Ce, the second component B representing at least one of the elements Al and Ga, **characterized in that** the first component A contains a rare earth RE selected from the group consisting of Y, Tb, La and/or Lu, with an amount of at most 5 Mol%, in particular at most 1 Mol%, of A being replaced by praseodymium, with praseodymium acting as a second activator in addition to Ce, in accordance with the formula $A_3B_5O_{12}$: (Ce, Pr).

**2.** Phosphor according to Claim 1, **characterized in that** the first component A additionally contains Gd and/or Sc as a non-luminous constituent of the host lattice.

**3.** Phosphor according to Claim 1, **characterized in that** the first component A is formed predominantly, in particular to an extent of more than 75 Mol%, by yttrium.

**4.** Phosphor according to Claim 1, **characterized in that** the phosphor can be excited by radiation in the range from 430 to 470 nm, in particular with a peak wavelength in the range from 440 to 465 nm.

**5.** Phosphor according to Claim 3, **characterized in that** the first component, in addition to Y and/or Lu, uses fractions of Tb, Sc, Gd and/or La, in particular a fraction of 0.1 to 20 Mol% of Tb.

**6.** Phosphor according to Claim 1, **characterized in that** a garnet of the overall structure $(RE_{1-x-y}Pr_xCe_y)_3(Al,Ga)_5O_{12}$ is used, where
RE=Y, Sc, Tb, Gd, La and/or Lu;
with a concentration of the two activators Pr and Ce within the following ranges:

$$0.00005 \le x \le 0.05;$$

$$0.01 \le y \le 0.2.$$

**7.** Phosphor according to Claim 1, **characterized in that** the second component B contains both Al and Ga, and in particular additionally contains In.

**8.** Phosphor according to Claim 1, **characterized in that** the praseodymium content and the condition of the host lattice are selected in such a way that substantially lines of Pr below 650 nm appear in the emission spectrum, in particular the two lines of Pr at 609 and 611 nm.

**9.** Phosphor according to Claim 8, **characterized in that** the praseodymium content is less than 0.3 Mol% and in particular is selected to be so low that the two lines of Pr at 609 and 611 nm appear in spatially resolved form in the emission spectrum.

**10.** Phosphor according to Claim 8, **characterized in that** the praseodymium content is over 0.02 Mol% and is selected to be sufficiently high for the Pr line at 637 nm to appear in the emission spectrum.

**11.** Light source which primarily emits radiation in the short-wave region of the optical spectral region in the wavelength range from 420 to 490 nm, this radiation being partially or completely converted into secondary longer-wave radiation by means of a phosphor, in particular a single phosphor, according to one of the preceding claims.

**12.** Light source according to Claim 9, **characterized in that** the radiation is converted into longer-wave radiation by means of two phosphors according to one of Claims 1 to 8.

**13.** Light source according to Claim 9, **characterized in that** it has the following features, in order to realize a white-emitting LED:

a light-generating device, in particular a blue emitting light-emitting diode, which emits the primary radiation;
a wavelength-conversion device, which is connected to the light-generating device, the primary radiation penetrating into the wavelength-conversion device, where it is partially converted into the secondary longer-wave radiation, the wavelength-conversion device comprising at least one, in particular a single one, of the phosphors according to Claims 1 to 8, the wavelength-conversion device also comprising a potting compound in which the phosphor(s) are dispersed.

**14.** Light source according to Claim 9, **characterized in that** the radiation which is primarily emitted lies in the wavelength region from 430 to 470 nm.

**15.** Light source according to Claim 9, **characterized in that** a blue-emitting light-emitting diode based on InGaN, the peak emission wavelength of which is in the range from 440 to 465 nm, is used as the primary radiation source.

**16.** Process for producing a phosphor according to one of Claims 1 to 6, **characterized by** the following process steps:

a. comminution of the oxide and addition of a flux;

b. first annealing in forming gas;

c. milling and screening;

d. second annealing

**Revendications**

**1.** Substance luminescente pour l'excitation par une source de rayonnement émettant de la lumière, dont l'émission se trouve dans le domaine spectral visible d'ondes courtes entre 420 et 490 nm, ayant une structure $A_3B_5O_{12}$ de grenat qui est activée par du Ce, le deuxième constituant B représentant au moins l'un des éléments Al et Ga, **caractérisée en ce que** le premier constituant A contient un métal de terre rare SE choisi dans le groupe Y, Tb, La et/ou Lu, une proportion au maximum de 5 % en mole, notamment d'au plus 1 % en mole, de A étant remplacée par du praséodyme et le praséodyme agissant en tant que deuxième activateur à côté de Ce, conformément à la formule $A_3B_5O_{12}$ : (Ce, Pr).

**2.** Substance luminescente suivant la revendication 1, **caractérisée en ce que** le premier constituant A contient en plus Gd et/ou Sc comme élément constitutif non luminescent du réseau hôte.

**3.** Substance luminescente suivant la revendication 1, **caractérisée en ce que** le premier constituant A est formé d'une manière prépondérante, notamment pour plus de 75 % en mole, par de l'yttrium.

**4.** Substance luminescente suivant la revendication 1, **caractérisée en ce que** la substance luminescente peut être excitée par un rayonnement dans le domaine de 430 à 470 nm, notamment par une longueur d'onde de crête dans le domaine de 440 à 465 nm.

**5.** Substance luminescente suivant la revendication 3, **caractérisée en ce que** le premier constituant utilise, outre Y et/ou Lu, des proportions de Tb, Sc, Gd et/ou La, notamment une proportion de 0,1 à 20 % en mole de Tb.

**6.** Substance luminescente suivant la revendication 1, **caractérisée en ce qu'**il est utilisé un grenat de structure globale $(SE_{1-x-y}Pr_xCe_y)_3(Al,Ga)_5O_{12}$, dans laquelle
SE = Y, Sc, Tb, Gd, La et/ou Lu ;
avec une concentration des deux activateurs Pr et Ce dans l'intervalle :

$$0{,}00005 \le x \le 0{,}05\ ;$$

$$0{,}01 \le y \le 0{,}2.$$

**7.** Substance luminescente suivant la revendication 1, **caractérisée en ce que** le deuxième constituant B contient à la fois Al et Ga et, notamment, contient en plus In.

**8.** Substance luminescente suivant la revendication 1, **caractérisée en ce que** la proportion du praséodyme et la nature du réseau hôte sont choisies de façon à ce qu'il apparaisse essentiellement des raies du Pr en dessous de 650 nm dans le spectre d'émission, notamment les deux raies du Pr à 609 et à 611 nm.

**9.** Substance luminescente suivant la revendication 8, **caractérisée en ce que** la proportion du praséodyme est inférieure à 0,3 % en mole, et notamment, est choisie si petite que les deux raies du Pr à 609 et 611 nm apparaissent en étant résolues de manière séparée dans le spectre d'émission.

**10.** Substance luminescente suivant la revendication 8, **caractérisée en ce que** la proportion du praséodyme est supérieure à 0,02 % en mole et est choisie si grande que la raie du Pr à 637 nm apparaît dans le spectre d'émission.

**11.** Source de lumière qui émet primairement du rayonnement dans le domaine des ondes courtes du domaine visible du spectre dans le domaine des longueurs d'onde de 420 à 490 nm, ce rayonnement étant transformé en tout ou partie au moyen d'une substance luminescente, notamment unique, suivant l'une des revendications précédentes en du rayonnement secondaire d'ondes plus grandes.

**12.** Source de lumière suivant la revendication 9, **caractérisée en ce que** le rayonnement est transformé au moyen de deux substances luminescentes suivant l'une des revendications 1 à 8 en du rayonnement d'ondes plus grandes.

**13.** Source de lumière suivant la revendication 9, **caractérisée en ce qu'**elle a les caractéristiques suivantes pour réaliser une diode électroluminescente émettant dans le blanc :

un dispositif de production de lumière, notamment une diode luminescente émettant dans le bleu, qui émet le rayonnement primaire ;
un dispositif de transformation des longueurs d'onde qui est raccordé au dispositif de production de lumière, le rayonnement primaire pénétrant dans le dispositif de transformation des longueurs d'onde et y étant transformé en partie en le rayonnement secondaire d'ondes plus grandes, le dispositif de transformation des longueurs d'onde comprenant au moins notamment une seule des substances luminescentes suivant la revendication 1 à 8, le dispositif de transformation des longueurs d'onde comprenant, en outre, une composition de scellement dans laquelle la ou les substances luminescentes sont dispersées.

**14.** Source de lumière suivant la revendication 9, **caractérisée en ce que** le rayonnement émis en primaire est dans le domaine des longueurs d'onde allant de 430 à 470 nm.

**15.** Source de lumière suivant la revendication 9, **caractérisée en ce qu'**il est utilisé comme source de rayonnement primaire une diode électroluminescente émettant dans le bleu à base de InGaN, dont la longueur d'onde d'émission de crête est dans le domaine allant de 440 à 465 nm.

**16.** Procédé de production d'une substance luminescente suivant l'une des revendications 1 à 6, **caractérisé par** les stades de procédé suivants :

a. broyage des oxydes et addition d'un flux ;
b. premier passage au four dans du gaz de formage ;
c. broyage et tamisage ;
d. deuxième passage au four.

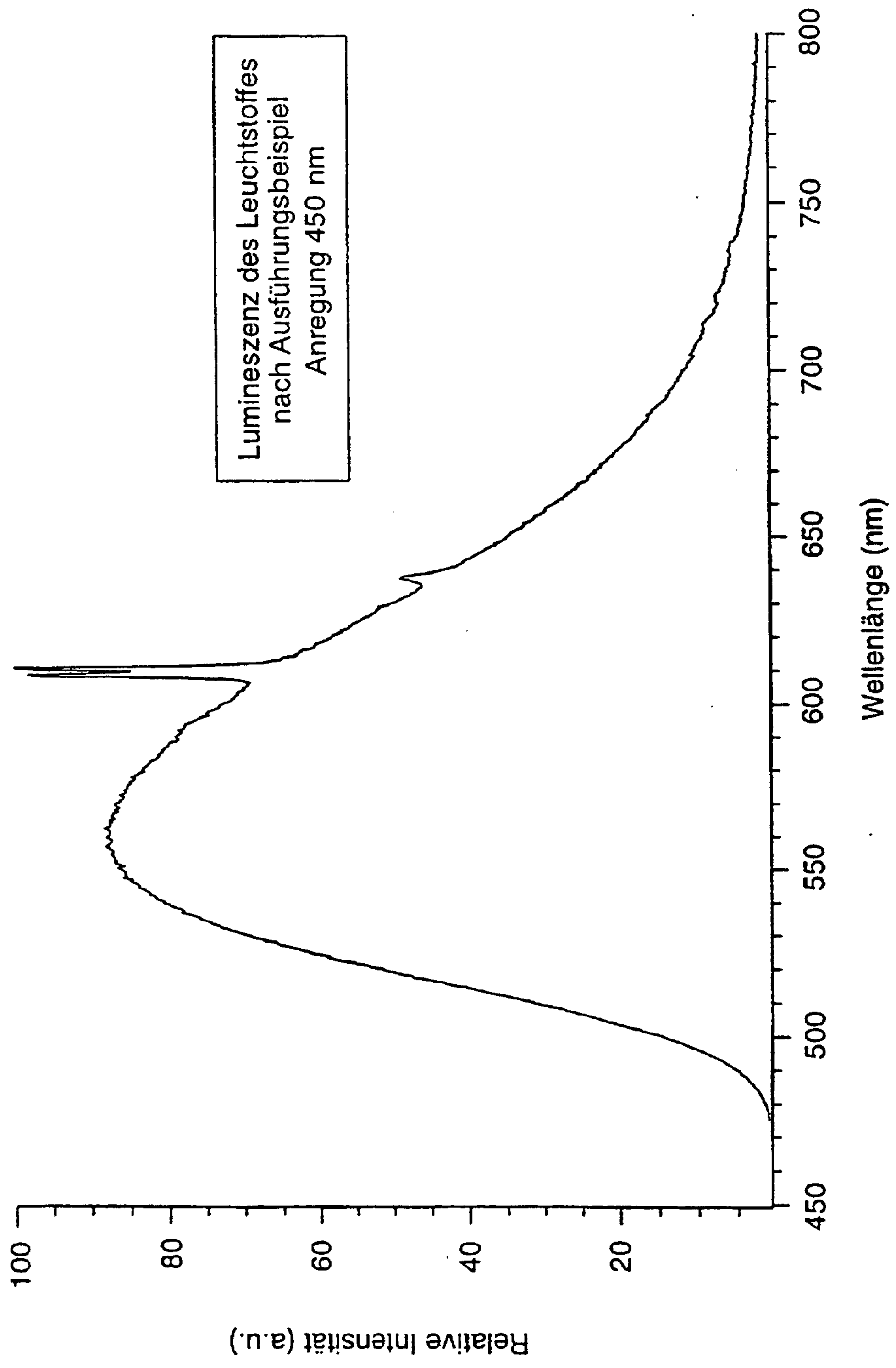
Lumineszenz des Leuchtstoffes
nach Ausführungsbeispiel
Anregung 450 nm
Relative Intensität (a.u.)
100
80
60
40
20
450
500
550
600
650
700
750
800
Wellenlänge (nm)

FIG. 1

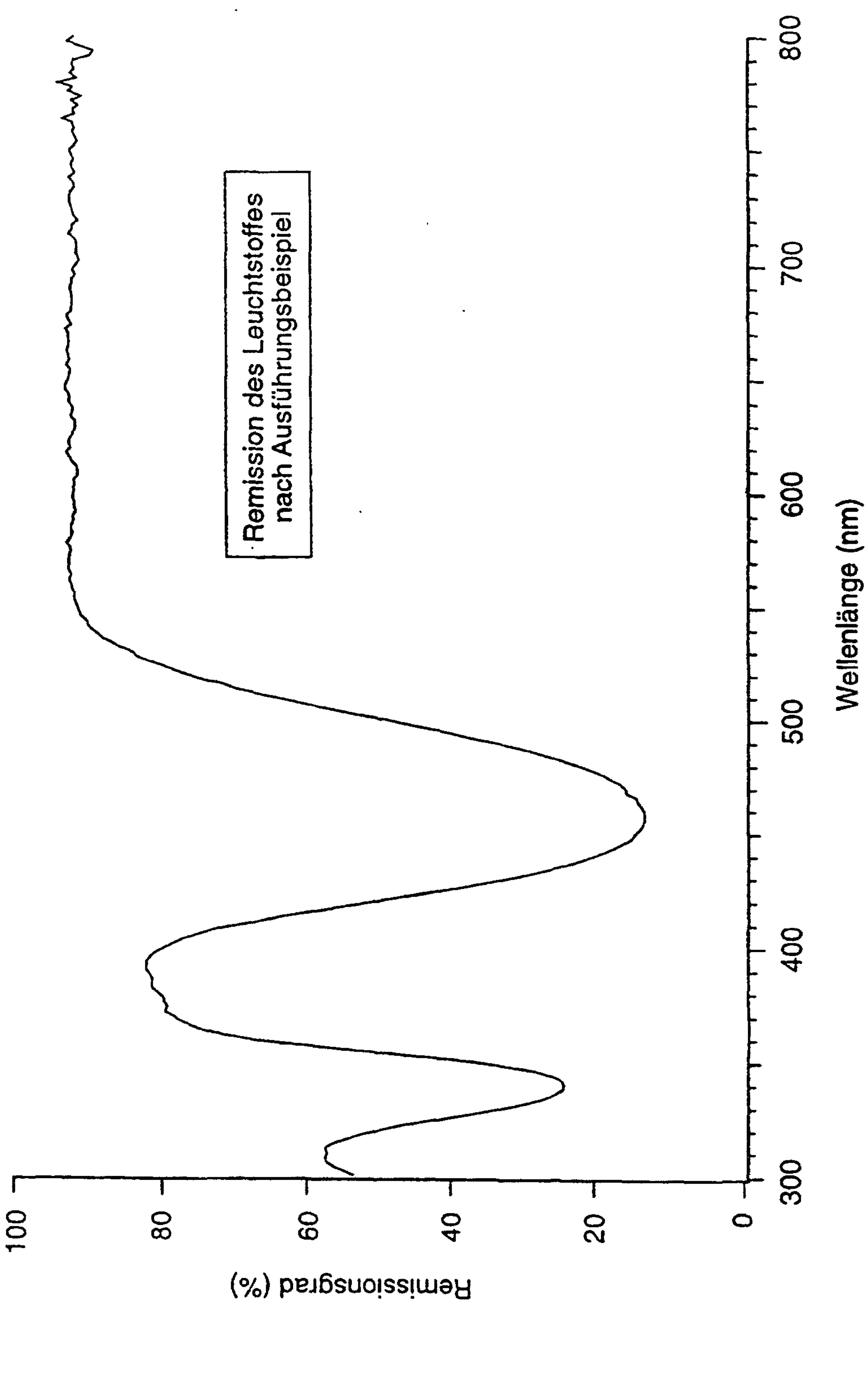
Remission des Leuchtstoffes nach Ausführungsbeispiel
Remissionsgrad (%)
0
20
40
60
80
100
Wellenlänge (nm)
300
400
500
600
700
800

FIG. 2

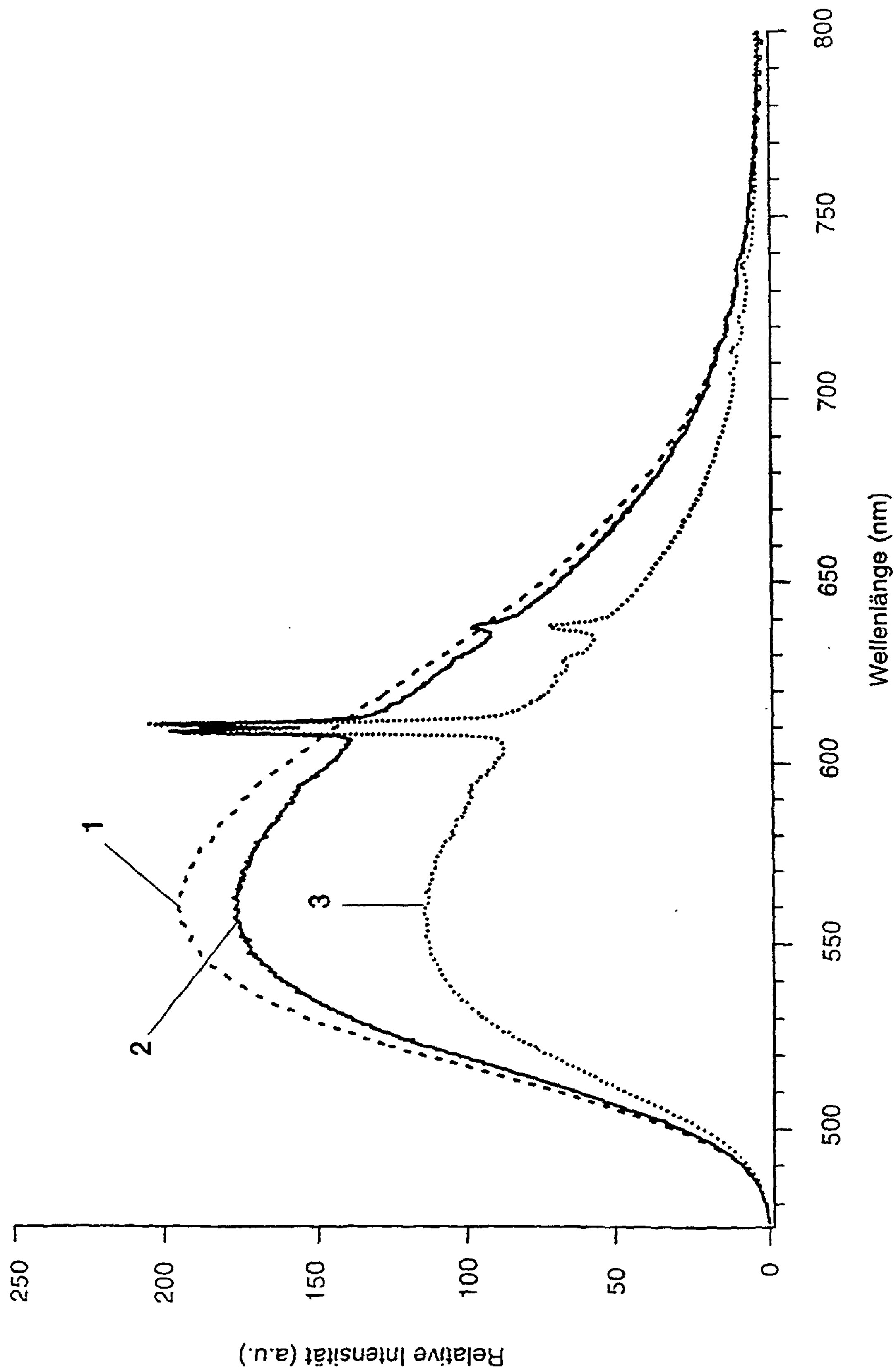
Relative Intensität (a.u.)
250
200
150
100
50
0
500
550
600
650
700
750
800
Wellenlänge (nm)
1
2
3

FIG. 3

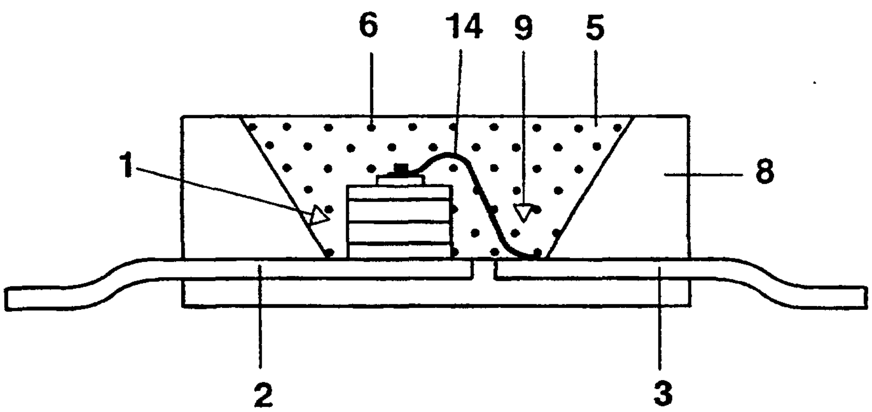


FIG. 4

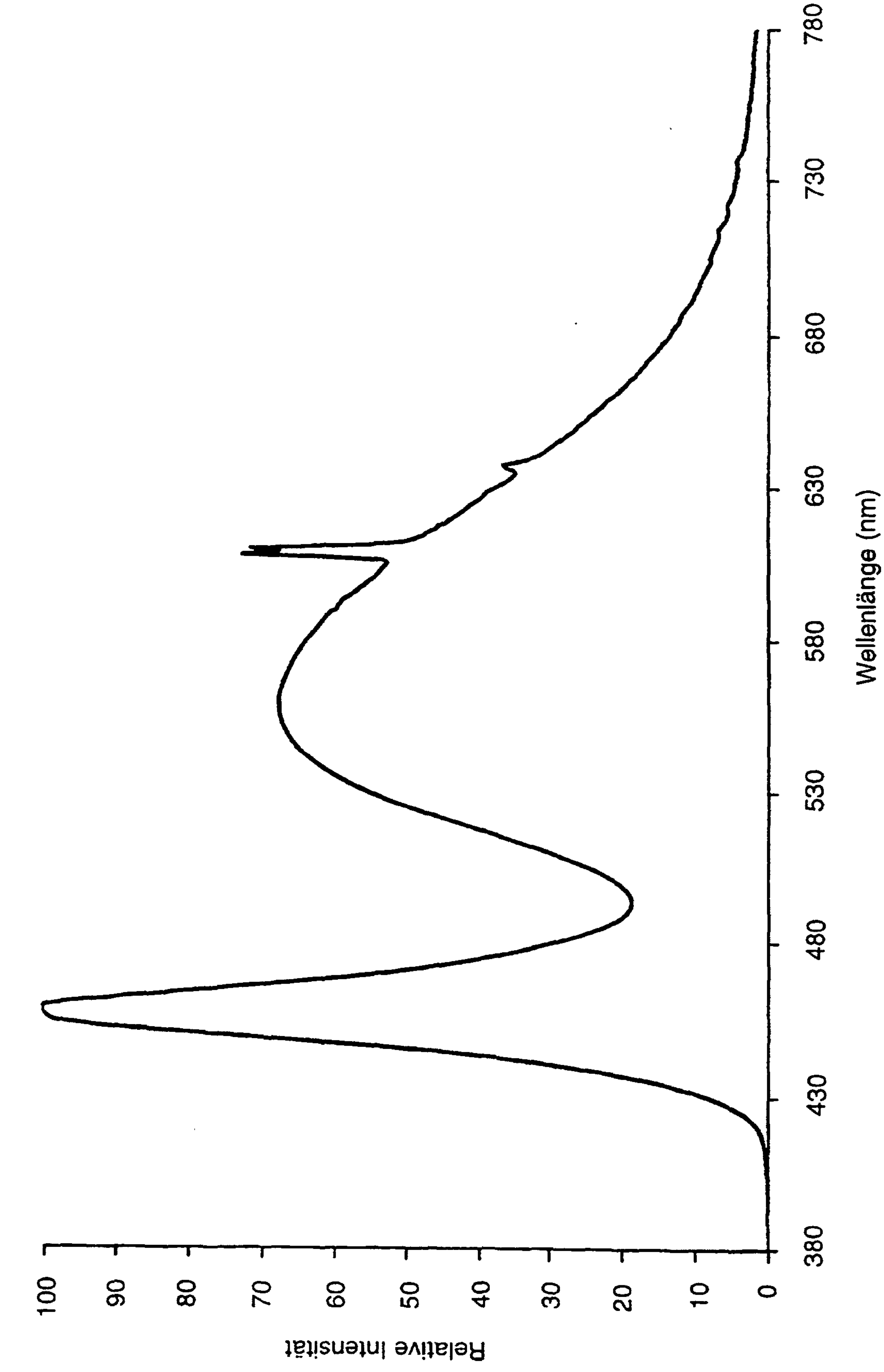
Relative Intensität
100
90
80
70
60
50
40
30
20
10
0
380
430
480
530
580
630
680
730
780
Wellenlänge (nm)

FIG. 5